# EUROPÄISCHE PATENTSCHRIFT

(11) **EP 2 413 503 B1**
(45) Veröffentlichungstag und Bekanntmachung des Hinweises auf die Patenterteilung: **11.06.2014**
(21) Anmeldenummer: 11172454.8
(22) Anmeldetag: 04.07.2011
(51) Int. Cl.: H03K 17/18, H04L 25/49, H02M 1/08, H03K 17/689, H03K 17/08

(54) **Verfahren zum Betreiben eines PWM-Augangs eines Treibers für einen Leistungshalbleiter**
Method for operating a PWM output of a driver for a power semiconductor
Procédé de fonctionnement d'une sortie PWM d'un pilote pour un semi-conducteur de puissance

(30) Priorität: 30.07.2010 DE 102010038735
(43) Veröffentlichungstag der Anmeldung: 01.02.2012
(73) Patentinhaber: SEMIKRON Elektronik GmbH & Co. KG, 90431 Nürnberg (DE)
(72) Erfinder: Hofmair, Markus, 91154 Roth (DE)

(56) Entgegenhaltungen:
- EP-A2- 1 633 046
- US-A1- 2008 044 165

## Beschreibung

Die Erfindung betrifft ein Verfahren zum Betreiben eines PWM-Ausgangs eines Treibers für einen Leistungshalbleiter.

Leistungshalbleiter, zum Beispiel IGBTs (Insulate Gate Bipolar Transistor) benötigen zu ihrer Ansteuerung in der Regel einen Treiber. Der Treiber wandelt ein leistungsschwaches Logiksignal in ein leistungsstarkes Schaltsignal um, welches dann dem Schalteingang des Leistungshalbleiters, z.B. dem Gate des IGBT, direkt zugeführt werden kann und diesen letzten Endes schaltet.

Ein Treiber weist hierbei in der Regel neben seiner eigentlichen Schaltfunktion verschiedene Nebenfunktionen auf. Z.B. wird eine Temperatur oder Spannung, also Analogwerte, am Leistungshalbleiter gemessen oder ein Ja/Nein-Fehlersignal, also ein binärer Zusatzwert, bei Versagen des Treibers oder Halbleiters erzeugt. Gängige Spannungswerte sind hier z.B. 0―10V. Sowohl ein solcher Analogwert als auch ein binärer Zusatzwert werden vom Treiber ausgegeben. Hierfür besitzt dieser in der Regel einen PWM-Ausgang, um den Analogwert in Form eines PWM-Signals auszugeben. Zusätzlich wird der binäre Wert an einem zusätzlichen Ausgang ausgegebene. Ein Kunde, der den Treiber einsetzt, beschaltet die betreffenden Ausgänge nach seinen Wünschen, um die dort anliegenden Signale weiterzuverarbeiten. Mit anderen Worten schließt sich an den Ausgang eine Übertragerstrecke zur Kundenlogik an.

Der Analogwert wird innerhalb des Treibers in ein PWM-Signal mit fester PWM-Frequenz überführt. Der PWM-Ausgang weist dabei einen ersten (Hi) und einen zweiten (Lo) Signalpegel des PWM-Signals auf, zwischen diesen der PWM-Ausgang alterniert. Da auch die Übertragerstrecke nur die beiden Signalpegel aufweist, ist diese als digital zu verstehen und z.B. über Lichtwellenleiter realisierbar. Mit anderen Worten wird der zu übertragende Analogwert bzw. das analoge Signal von einem Sender in ein PWM-Signal mit fester Frequenz umgewandelt. Je länger innerhalb eines PWM-Taktes der Signalpegel dabei auf 1 liegt, desto höher ist der zu sendende Analogwert.

Auf der Empfängerseite, d.h. am Ende der Übertragungsstrecke, also in der vom Kunden angeschlossenen Schaltung gibt ein Empfänger für den jeweiligen der beiden Signalpegel wiederum einen definierten Pegel aus. Der Empfänger kann hierbei sowohl analog als auch digital realisiert werden. Bei einem analogen Empfänger wird z.B. über einen Tiefpass, wie ein RC-Glied, das empfangene PWM-Signal in einen analogen Ausgangswert geglättet. Bei einer digitalen Auswertung tastet der Empfänger das PWM-Signal bekannter Frequenz ab. Die Abtastrate des Empfängers bestimmt hierbei dessen Genauigkeit.

Bekannt ist es, den binären Zusatzwert auf einer zweiten Übertragungsstrecke, welche ebenfalls zwei Signalpegel aufweist, z.B. eine zweite Lichtleitfaser, separat zu übertragen.

Aus der EP 1 633 046 A2 ist eine digitale Signalübertragungsvorrichtung, die mittels einer Modulationseinrichtung aus einem digitalen Eingangssignal ein moduliertes Signal generiert und das modulierte Signal über einen Pulsübertrager an eine Demodulationseinrichtung überträgt, bekannt.

Aus der US 2008/044165 A1 ist eine Motoransteuereinrichtung, die einen Motor auf Basis eines pulsmodulierten externen Steuersignals ansteuert, bekannt.

Aufgabe der vorliegenden Erfindung ist es, ein verbessertes Verfahren zum Betreiben eines PWM-Ausgangs eines Treibers für einen Leistungshalbleiter anzugeben.

Die Aufgabe wird gelöst durch ein Verfahren gemäß Patentanspruch 1. Der vom Treiber auszugebende Analogwert wird wie üblich in ein einen ersten und zweiten Signalpegel aufweisendes PWM-Signal fester PWM-Frequenz überführt.

Gemäß dem Verfahren wird für den Fall, dass der Zusatzwert seinen ersten Wert aufweist, das PWM-Signal - wie im Stand der Technik bekannt bzw. wie üblich - mit Hilfe der zwei Signalpegel über die Übertragungsstrecke übertragen. Das PWM-Signal wird also wie üblich am PWM-Ausgang ausgegeben.

Nimmt der Zusatzwert jedoch seinen anderen, also den zweiten Wert an, wird das PWM-Signal zusammen mit einem Zusatzsignal am PWM-Ausgang ausgegeben. Das Zusatzsignal wird hierbei folgendermaßen gebildet: Mit einer Signalfrequenz größer der PWM-Frequenz wird der gemäß Vorschrift des PWM-Signals anliegende erste oder zweite Signalpegel und im Wechsel hierzu bzw. alternierend der jeweils andere Signalpegel ausgegeben.

Mit anderen Worten wird erfindungsgemäß, solange der binäre Zusatzwert seinen ersten - auch inaktiv genannten - Wert annimmt, das PWM-Signal wie gewohnt vom Treiber ausgegeben. Bei Auftreten bzw. Anliegen des zweiten Wertes des Zusatzwertes hingegen wird zusätzlich zum PWM-Signal ein hochfrequentes (Signalfrequenz größer der PWM-Frequenz) Signal ausgegeben. Das zusätzliche Signal besteht mit anderen Worten darin, den aktuellen PWM-Pegel hochfrequent zum anderen Pegel hin zu alternieren. Insbesondere ist die Signalfrequenz wesentlich größer als die PWM-Frequenz, also z.B. um einen Faktor, 5, 10, 20, 50, 100 oder mehr größer.

Der Analogwert ist z.B. ein vom Treiber am Leistungshalbleiter bestimmter Temperatur- oder Spannungswert. Der Zusatzwert ist z.B. ein binäres Fehlersignal, das für fehlerfreien Betrieb eine Null als ersten, sonst eine Eins als zweiten Wert liefert.

Mit anderen Worten wird also beim zweiten Wert des Zusatzwertes das bisherige PWM-Signal mit einem vergleichsweise hochfrequenten Zusatzsignal überlagert.

Am Ende der Übertragungsstrecke kann weiterhin das am PWM-Ausgang ausgegebene Gesamtsignal analog und/oder digital ausgewertet werden. Hierbei wird z.B. das Zusatzsignal durch einen analogen Hochpass vom PWM-Signal getrennt und beide Signale getrennt ausgewertet. Eine digitale Auswertung des Zusatzsignals kann z.B. mit einer Abtastfrequenz, welche größer dem doppelten der Signalfrequenz ist, erfolgen. Das PWM-Signal wird dagegen wie bekannt durch ein geeignetes Auswerteverfahren in den Analogwert rückgeführt.

In der Regel ist der Zusatzwert von höherer Priorität als der Analogwert. Z.B. ist das zeitnahe Erkennen eines Fehlersignals wichtiger als in diesem Zeitpunkt - dem Auftreten des dem Fehlersignal zugeordneten Fehlers - auch die korrekte Temperatur zu kennen. Bei Senden des Zusatzsignals ist es daher tolerierbar, dass dann der Analogwert, d.h. das Auswertungsergebnis des eigentlichen PWM-Signales verfälscht wird. Der Analogwert ist in einem derartigen Fall von untergeordneter Bedeutung und dessen Information darf zerstört werden.

Wünschenswert ist dennoch, die Information des Analogwertes auch bei Anliegen des Zusatzsignals nicht zu zerstören. Das ausgegebene PWM-Signal wird in der Regel an einem Empfänger durch ein Auswerteverfahren in den Analogwert rückgeführt. Das Auswerteverfahren sei im folgenden bekannt.

Erfindungsgemäß werden bei bekanntem Auswerteverfahren im Zusatzsignal die Signalpegel innerhalb eines PWM-Taktes in Abhängigkeit des Auswerteverfahrens so gewählt, dass der Analogwert als Ergebnis des Auswerteverfahrens erhalten bleibt.

Am Ende des Auswerteverfahrens ergibt sich so der Analogwert, unabhängig davon, ob das Zusatzsignal auf das PWM-Signal aufmoduliert ist oder nicht. Mit anderen Worten wird das Zusatzsignal derart gestaltet, dass es bezüglich des PWM-Signals bzw. dessen Auswerteverfahren z.B. mittelwertfrei ist, also das Ergebnis des Auswerteverfahrens nicht verfälscht. Der Analogwert bleibt damit auch während der Übertragung des Zusatzsignals auswertbar bzw. erhalten.

Für eine solche Gestaltung des Zusatzsignals, also mit anderen Worten die Bedingungen, z.B. die Zeitvorschriften, gemäß denen bei Anliegen des Zusatzsignals der Signalpegel zu alternieren ist, existieren verschiedene Varianten:
In einer ersten Variante wird das Zusatzsignal ausschließlich nur dann ausgegeben, wenn das PWM-Signal entweder den ersten oder den zweiten Signalpegel annimmt. Voraussetzung hierfür ist, dass im PWM-Signal jeder PWM-Takt jeweils beide Signalpegel aufweist. Mit anderen Worten wird also das Zusatzsignal nur während eines Hi- oder eines Lo-Pegels des PWM-Signals übertragen. Diese Variante bietet sich insbesondere in Kombination mit einer digitalen Auswertung am Ende der Übertragungsstrecke an. In dieser Ausführungsform werden die zeitlichen Grenzen des Pegelwechsels im ursprünglichen PWM-Signal weiterhin eingehalten. Eine digitale Auswertung kann so trotz Zusatzsignal die Pegelgrenzen des ursprünglichen PWM-Signals innerhalb des PWM-Taktes sicher erkennen. Das Tastverhältnis des PWM-Signals und damit der Analogwert kann dann korrekt rekonstruiert werden.

Nachteilig hierbei ist jedoch, dass sich die Übertragung und Detektion eines Signalwechsels im Zusatzsignal eventuell um die maximale Dauer des Hi- oder Lo-Pegels des PWM-Signals, also maximal um etwa einen PWM-Takt verzögern kann. Für bezüglich des Zusatzwertes besonders zeitkritische Anwendungen ist diese Variante also nicht geeignet.

In einer alternativen erfindungsgemäßen Ausführungsform, welche sich besonders für die analoge Auswertung am Ende der Übertragungsstrecke anbietet, wird das Zusatzsignal so gewählt, dass innerhalb eines PWM-Taktes die durch das Zusatzsignal im Zeitintervall des ersten Signalpegels des PWM-Signals entfernten Signalanteile mit den durch das Zusatzsignal hinzugefügten Signalanteilen beim zweiten Signalpegel des PWM-Signals wiederhergestellt werden.

Mit anderen Worten wird im Falle des Anliegen des Zusatzsignales die hochfrequenten Wechsel der Signalpegel so gewählt, dass der für eine Rekonstruktion des Analogwertes relevante Signalgehalt, insbesondere z.B. der Integralwert unter einem Signalverlauf während eines PWM-Taktes erhalten bleibt.

Zum Beispiel werden durch Anlegen des Zusatzsignals im Hi-Pegel des PWM-Signals auch Lo-Pegel erzeugt, die gegenüber dem ursprünglichen PWM-Signal den vom Signal überstrichenen Integralwert schmälern. Im Lo-Pegel des ursprünglichen PWM-Signals werden daher durch das Zusatzsignal zusätzliche Hi-Pegel im restlichen Verlauf des PWM-Taktes erzeugt, die den oben geschmälerten Integralwert wieder ausgleichen.

Diese Verfahrensvariante erhält z.B. bei einer Tiefpassfilterung des PWM-Signals stets den Wert des ursprünglichen PWM-Signals innerhalb eines PWM-Taktes auch bei Anliegen des Zusatzsignals. Mit anderen Worten wird das Zusatzsignal so auf das PWM-Signal abgestimmt, dass dessen auf die Auswertung bezogener Signalgehalt unverändert bleibt und somit das Auswerteverfahren einen unveränderten Wert liefert.

In einer weiteren bevorzugten Ausführungsform des Verfahrens wird die Signalfrequenz des Zusatzsignals abhängig von einer weiteren Zusatzinformation verändert. Bei dieser Ausgestaltung wird nicht nur das binäre Zusatzsignal als aktiv bzw. inaktiv übertragen. Durch eine entsprechende Wahl verschiedener Signalfrequenzen können zusätzlich verschiedene Werte eines Zusatzsignals übertragen werden. Im idealen Fall ist durch eine feinstufige bzw. kontinuierliche Veränderung der Signalfrequenz - zusätzlich zum Zusatzwert und zumindest alternativ zum ursprünglichen Analogwert - noch ein weiterer, mit dem Zusatzwert gekoppelter Analogwert in Form einer Frequenzkodierung über die gleiche Übertragungsstrecke übertragbar. Das Zusatzsignal wird allerdings nur dann übertragen, wenn der Zusatzwert aktiv ist.

Für eine weitere Beschreibung der Erfindung wird auf die Ausführungsbeispiele der Zeichnungen verwiesen. Es zeigen, jeweils in einer schematischen Prinzipskizze:
Fig.1 einen erfindungsgemäßen Treiber mit Auswerteschaltung,
Fig.2 ein PWM-Signal mit Zusatzsignal.

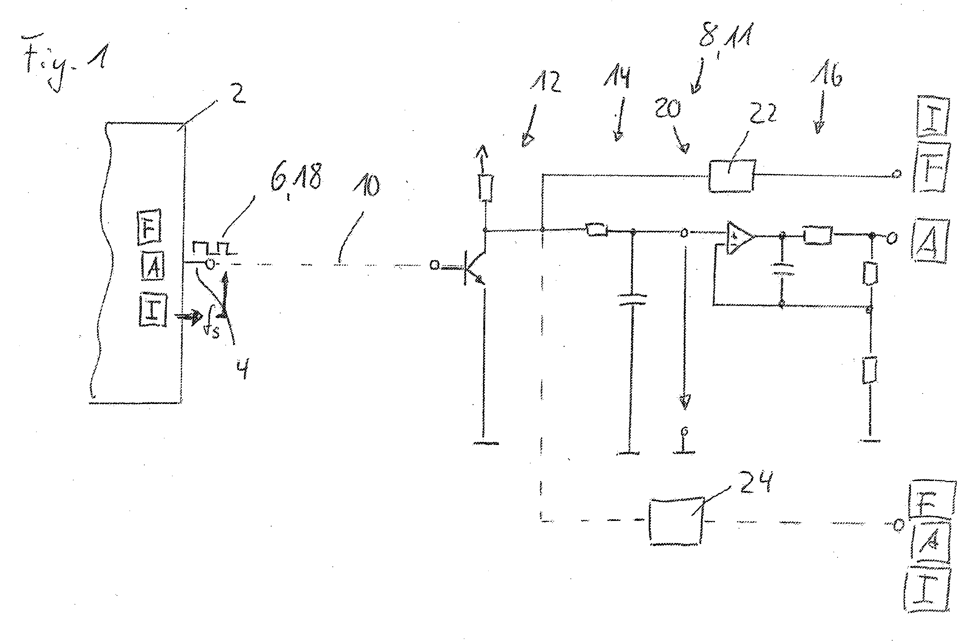

Fig.1 zeigt einen Treiber 2 für einen nicht dargestellten Leistungshalbleiter mit einem PWM-Ausgang 4. Am PWM-Ausgang 4 soll als Analogwert A eine Temperatur des Leistungshalbleiters als PWM-Signal 6 ausgegeben werden. Die Ausgabe, d.h. die Details wie Timing etc. des PWM-Signals erfolgt gemäß Spezifikation eines Herstellers des Treibers 2. Fig.1 zeigt außerdem eine Auswerteschaltung 8 als Empfänger 11, die ein Kunde bzw. Käufer des Treibers 2 entwirft bzw. aufbaut, um das PWM-Signal 6 wieder in den Analogwert A zurückzuwandeln. Die Übertragung des PWM-Signals 6 erfolgt über einen Lichtwellenleiter als Übertragungsstrecke 10. Die Auswerteschaltung 8 umfasst einen an der Übertragungsstrecke 10 angeschlossenen Empfangsverstärker 12, einen analogen Tiefpassfilter 14 und einen analogen Verstärker 16. Die Auswerteschaltung 8 arbeitet also analog.

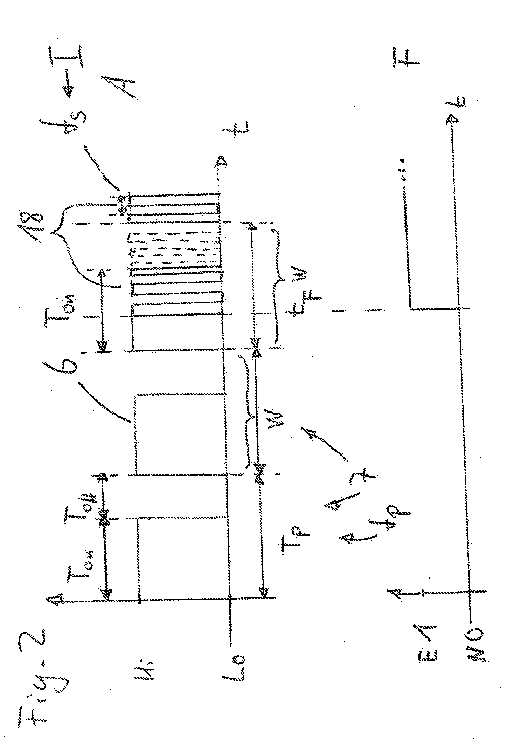

Fig.2 zeigt das PWM-Signal 6 im Detail über der Zeit t am Beispiel der Übertragung eines zwölf-bit-Wertes, d.h. von Werten zwischen 0 und 2¹²-1=4095. Z.B. entspricht dabei eine Temperatur von 0°C einem Wert von 0 und eine von 300°C einem Wert von 4095. Fig.2 zeigt die Übertragung eines Analogwertes von 200°C als Wert 2730. Das PWM-Signal 6 besitzt eine konstante PWM-Frequenz f_{P}, d.h. jeder PWM-Takt 7 hat die selbe Periodendauer Tp. Gemäß des bekannten PWM-Verfahrens wird daher innerhalb eines PWM-Taktes für die On-Zeit Tₒₙ von 2730/4095*Tp ein erster, hoher Signalpegel Hi angelegt, und für die Restdauer, also Off-Zeit T_{off}=T_{P}-Tₒₙ=4095-(2730/4095*TP) ein zweiter niedriger Signalpegel LO.

Zusätzlich soll der Treiber 2 außerdem einen binären Zusatzwert F, nämlich ein Fehlersignal ausgeben, das einen ersten Wert N von null (kein Fehler) und einen zweiten Wert E von eins (Fehler) annehmen kann. Erfindungsgemäß erfolgt die Ausgabe ebenfalls über den PWM-Ausgang 4.

Im PWM-Signal 6 in Fig.2 ist zunächst der Zusatzwert F inaktiv, d.h. er weist seinen Ersten Wert N gleich null auf. Erst zum Fehlerzeitpunkt t_{F} entsteht ein Fehler im Treiber 2, der kommuniziert werden soll. Erfindungsgemäß wird daher ab dem Fehlerzeitpunkt t_{F}, also wenn das Fehlersignal F aktiv wird bzw. seinen zweiten Wert E gleich eins annimmt, ein Zusatzsignal 18 ausgegeben. Gemäß diesem wird mit einer Signalfrequenz f_{S}, die größer der PWM-Frequenz f_{P}=1/T_{P} ist, alternierend der gemäß dem ursprünglichen PWM-Signal gültige aktuelle Signalpegel Hi des PWM-Signals 6 und im Wechsel hierzu der andere Pegel - in diesem Fall Lo - über die Übertragungsstrecke 10 übertragen. Dies geschieht bis zum Ende der On-Zeit Tₒₙ. Am Ende der On-Zeit Tₒₙ wird die Übertragung des Zusatzsignals 18 bis zum nächsten PWM-Takt unterbrochen, um das Signal auf Lo zu halten.

Alternativ zu der in Fig.1 gezeigten analogen Variante der Signalauswertung mit Tiefpassfilter 14 und Hochpassfilter 22 kann auch eine gestrichelt gezeichnete digitale Auswertung durch einen Abtastschaltung 24 erfolgen, welche dann sowohl den Analogwert A als auch das detektierte Zusatzsignal F ausgeben kann.

Da gemäß oben die PWM-Information im Signal nicht zerstört ist, also die Off-Zeit T_{off} klar erkannt werden kann, bleibt der Analogwert A erhalten. So kann die Auswerteschaltung 12 noch immer den korrekten Analogwert A ausgeben. Für den Fall einer digitalen Auswertung wird also die Grenze der On-zeit Tₒₙ eingehalten, so dass der Analogwert A korrekt rekonstruiert werden kann.

Die Auswertung des Zusatzsignals F in der o.g. analogen Variante der Auswerteschaltung 18 erfolgt durch einen nach dem Empfangsverstärker 21 abzweigenden Hochpasszweig 20 mit einem Hochpassfilter 22 gemäß Fig. 1.

In einer alternativen Ausführungsform wird das Zusatzsignal 18 (gestrichelt dargestellt) auch während der Off-Zeit T-off fortgesetzt. Mit andern Worten wird durch Einfügen zusätzlicher Pulse des Zusatzsignals 18 in der Off-Zeit T_{off} der Integralwert W des Gesamtsignals pro PWM-Takt erhalten. D.h., die in der On-Zeit Tₒₙ "fehlenden" Hi-Signalanteile werden während der Off-Zeit T_{off} nachgereicht bzw. ergänzt, um eine analoge Auswertung wieder zum gleichen Analogwert A zu führen. Die vom Signalverlauf überstrichene Integralfläche des ursprünglichen PWM-Signals und des mit dem Zusatzsignal ergänzten Signalverlaufs sind dann gleich.

In Fig.2 besitzt das Zusatzsignal 18 eine feste Signalfrequenz f_{S}. In einer alternativen, nur symbolisch dargestellten Ausführungsform der Erfindung kann die Signalfrequenz fₛ noch anhand einer Zusatzinformation I verändert werden. Mit anderen Worten ist die Zusatzinformation I dann frequenzkodiert in der Signalfrequenz f_{S}. Auf Empfänger- bzw. Kundenseite kann die Zusatzinformation I dann wieder im Hochpasszweig 20 bzw. in der Abtastschaltung 24 aus dem empfangenen PWM-Signal 6 mit Zusatzsignal 18 rekonstruiert werden.

### Bezugszeichenliste

- 2: Treiber
- 4: PWM-Ausgang
- 6: PWM-Signal
- 8: Auswerteschaltung
- 10: Übertragungsstrecke
- 12: Empfangsverstärker
- 14: Tiefpassfilter
- 16: Verstärker
- 18: Zusatzsignal
- 20: Hochpasszweig
- 22: Hochpassfilter
- 24: Abtastschaltung

- A: Analogwert
- t: Zeit
- T_{P}: Periodendauer
- f_{P}: PWM-Frequenz
- Tₒₙ: On-Zeit
- T_{off}: Off-Zeit
- Hi,Lo: Signalpegel
- F: Zusatzwert
- t_{F}: Fehlerzeitpunkt
- fₛ: Signalfrequenz
- I: Zusatzinformation
- W: Integralwert
- N,E: Wert

## Patentansprüche

1. Verfahren zum Betreiben eines PWM-Ausgangs (4) eines Treibers (2) für einen Leistungshalbleiter, bei dem:
- ein vom Treiber auszugebender Analogwert (A) in ein einen ersten (Hi) und zweiten Signalpegel (Lo) aufweisendes PWM-Signal (6) fester PWM-Frequenz (f_{P}) überführt wird, und
- für einen ersten Wert (N) eines vom Treiber auszugebenden binären Zusatzwertes (F):
- das PWM-Signal (6) am PWM-Ausgang (4) ausgegeben wird,
- für einen zweiten Wert (E) des Zusatzwertes (F):
- das PWM-Signal (6) zusammen mit einem Zusatzsignal (18) am PWM-Ausgang (4) ausgegeben wird, wobei
- als Zusatzsignal (18) mit einer Signalfrequenz (f_{S}) größer der PWM-Frequenz (f_{P}) im Wechsel der gemäß dem PWM-Signal bestimmte erste (Hi) oder zweite Signalpegel (Lo) und der jeweils andere Signalpegel (Lo,Hi) ausgegeben werden, wobei das ausgegebene PWM-Signal (6) an einem Empfänger (11) durch ein bekanntes Auswerteverfahren in den Analogwert (A) rückgeführt wird, bei dem im Zusatzsignal (18) die Signalpegel (Hi,Lo) innerhalb eines PWM-Taktes (7) in Abhängigkeit des Auswerteverfahrens so gewählt werden, dass der Analogwert (A) als Ergebnis des Auswerteverfahrens erhalten bleibt und bei dem das Zusatzsignal (18) so gewählt wird, dass innerhalb eines PWM-Taktes (7) die durch das Zusatzsignal (18) im ersten Signalpegel (Hi) des PWM-Signals (6) entfernten Signalanteile mit den durch das Zusatzsignal hinzugefügten Signalanteilen beim zweiten Signalpegel (Lo) des PWM-Signals (6) wiederhergestellt werden, so dass die vom Signalverlauf überstrichene Integralflächen des ursprünglichen PWM-Signals und des mit dem Zusatzsignal ergänzten Signalverlaufs gleich sind.

2. Verfahren nach einem der vorhergehenden Ansprüche, bei dem die Signalfrequenz (f_{S}) des Zusatzsignals (18) abhängig von einer Zusatzinformation (I) verändert wird.

## Claims

1. A method for operating a PWM output (4) of a driver (2) for a power semiconductor, in which:
- an analogue value (A) to be outputted from the driver is translated into a PWM signal (6) of fixed PWM frequency (fₚ), having a first (Hi) and a second (Lo) signal level, and
- for a first value (N) of a binary complementary value (F) to be outputted from the driver:
- the PWM signal (6) is outputted at the PWM output (4),
- for a second value (E) of the complementary value (F) :
- the PWM signal (6) together with a complementary signal (18) is outputted at the PWM output (4), wherein
- the first (Hi) or second (Lo) signal level determined in accordance with the PWM signal, and the respectively other signal level (Lo, Hi), are alternately outputted as a complementary signal (18) with a signal frequency (fₛ) greater than the PWM frequency (fₚ), wherein the outputted PWM signal (6) on a receiver (11) is fed back by means of an evaluation method of known art into the analogue value (A), in which the signal levels (Hi, Lo) in the complementary signal (18) are selected within a PWM cycle (7) as a function of the evaluation method such that the analogue value (A) survives as a result of the evaluation method, and in which the complementary signal (18) is selected such that within a PWM cycle (7) signal components in the first signal level (Hi) of the PWM signal (6) removed by means of the complementary signal (18) are restored with the signal components added by means of the complementary signal in the second signal level (Lo) of the PWM signal (6), such that the integral surfaces overlaid by the signal profile of the original PWM signal, and of the signal profile complemented with the complementary signal, are equal .

2. The method in accordance with one of the preceding claims, in which the signal frequency (fₛ) of the complementary signal (18) is modified as a function of an item of complementary information (I).

## Revendications

1. Procédé de fonctionnement d'une sortie MLI (pour Modulation de Largeur d'Impulsion) (4) d'un pilote (2) pour un semi-conducteur de puissance, dans lequel :
- une valeur analogique (A) à émettre par le pilote est convertie en un signal MLI (6) à fréquence MLI (f_{P}) fixe présentant un premier (Hi) et un deuxième (Lo) niveau de signal, et
- pour une première valeur (N) d'une valeur additionnelle (F) à émettre par le pilote :
- le signal MLI (6) est émis sur la sortie MLI (4),
- pour une deuxième valeur (E) de la valeur additionnelle (F) :
- le signal MLI (6) est émis avec un signal additionnel (18) sur la sortie MLI (4),
- le premier (Hi) ou le deuxième (Lo) niveau de signal déterminé suivant le signal MLI et l'autre niveau de signal (Lo, Hi) respectif étant émis en alternance en tant que signal additionnel (18) avec une fréquence de signal (fₛ) supérieure à la fréquence MLI (f_{P}), le signal MLI (6) émis sur un récepteur (11) étant, au moyen d'un procédé d'analyse connu, ramené à la valeur analogique (A) où, dans le signal additionnel (18), le niveau de signal (Hi, Lo) est sélectionné à l'intérieur d'un cycle MLI (7) en fonction du procédé d'analyse, de manière à maintenir la valeur analogique (A) comme résultat du procédé d'analyse, et où le signal additionnel (18) est sélectionné de manière à rétablir, à l'intérieur d'un cycle MLI (7), les parts de signal supprimées par le signal additionnel (18) au premier niveau de signal (Hi) du signal MLI (6) avec les parts de signal ajoutées par le signal additionnel au deuxième niveau de signal (Lo) du signal MLI (6), si bien que les surfaces intégrales du signal MLI initial couvertes par la forme d'onde et de la forme d'onde complétée par le signal additionnel sont identiques.

2. Procédé selon la revendication 1, dans lequel la fréquence de signal (f_{S}) du signal additionnel (18) est modifiée en fonction d'une information additionnelle (I).
